# EUROPEAN PATENT APPLICATION

(11) **EP 4 803 256 A1**
(43) Date of publication of application: **09.09.2026**
(21) Application number: 24885383.0
(22) Date of filing: 08.10.2024
(51) Int. Cl.: B23Q 17/00, B23Q 11/10, G01R 22/06, G05B 19/18, G05B 19/409, G05B 19/418

(54) **MACHINE TOOL, POWER CONSUMPTION ESTIMATION METHOD, AND COMPUTER PROGRAM**

(30) Priority: 31.10.2023 JP 2023187083
(71) Applicant: BROTHER KOGYO KABUSHIKI KAISHA, Nagoya-shi, Aichi 467-8561 (JP)
(72) Inventor: ITO Tatsuya, Nagoya-shi, Aichi 467-8562 (JP)
(74) Representative: Becker, Eberhard
(86) International application number: PCT/JP2024/035911
(87) International publication number: WO 2025/094608

(57) **Abstract**

Provided are a machine tool, a power consumption estimation method, and a computer program with which it is possible to determine the power consumption of electric devices without using a power meter. A machine tool 100 according to the present disclosure is characterized by comprising electric devices (pumps 13, 14, 60) that receive alternating current, and an estimation unit (control unit of a control apparatus 72) that estimates the power consumption of the electric devices on the basis of the voltage and frequency of the alternating current received by the electric devices. The estimation unit estimates the power consumption of the electric devices on the basis of the voltage and frequency of the alternating current received by the electric devices, and the power consumption of the electric devices can therefore be determined without using a power meter.

## Description

### TECHNICAL FIELD

The disclosure relates to a machine tool, a power consumption amount estimation method, and a computer program.

### BACKGROUND ART

In the machine tool described in Patent Document 1, an integrating watt-hour meter integrates the amount of electric power received by the machine tool. The machine tool calculates the total amount of electric power used during a predetermined period based on the integration result of the integrating watt-hour meter.

### Related Art Document

### Patent Document

Patent Document 1: Japanese Patent Application Laid-Open No. 2002-243776

### SUMMARY OF INVENTION

### Problem to be Solved by the Invention

Patent Document 1 mentions the case of replacing the integrating watt-hour meter with an indicating watt-hour meter, but does not mention a case of omitting the watt-hour meter for directly determining the amount of electric power.

An object of the disclosure is to provide a machine tool, a power consumption amount estimation method, and a computer program that are capable of determining the power consumption amount of an electric device without using a watt-hour meter.

### Means for Solving the Problem

A machine tool according to the disclosure includes: an electric device that receives alternating current; and an estimation unit that estimates a power consumption amount of the electric device based on a voltage and a frequency of the alternating current received by the electric device.

In the disclosure, the electric device receives alternating current.

The estimation unit estimates the power consumption amount of the electric device based on the voltage and frequency of alternating current received by the electric device. Therefore, it is possible to determine the power consumption amount of the electric device without using a watt-hour meter.

The machine tool according to the disclosure further includes a detection unit that detects the voltage and the frequency, and the estimation unit estimates the power consumption amount based on a detection result of the detection unit.

In the disclosure, the detection unit detects the voltage and frequency of alternating current received by the electric device.

The estimation unit estimates the power consumption amount of the electric device based on the detection result of the detection unit.

There is no need for the user or manufacturer to set the respective values of voltage and frequency used by the estimation unit for estimation in the machine tool according to the region where the machine tool is installed or the usage environment of the machine tool, which improves the convenience for the user and manufacturer. Further, estimation errors of the power consumption amount caused by forgetting to set or incorrectly setting the voltage and frequency may be prevented. Furthermore, even in the case of the voltage or frequency of alternating current fluctuating during use of the machine tool, the estimation accuracy of the power consumption amount of the electric device is improved.

The machine tool according to the disclosure further includes a memory unit that stores the following equation (1) and constants a, b, and c for determining power consumption W based on the voltage V and the frequency f, and the estimation unit estimates the power consumption amount based on the following equation (1) and the constants stored in the memory unit. $W = aV + bf + c$

In the disclosure, the memory unit stores equation (1) and constants a, b, and c.

The estimation unit estimates the power consumption amount of the electric device based on equation (1) and constants a, b, and c stored in the memory unit.

By approximating the power consumption of the electric device with a simple linear equation, calculation for estimating the power consumption amount can be easily executed. The constants a, b, and c may be obtained experimentally, for example.

The machine tool according to the disclosure further includes a timing unit that times an operation time during which the electric device is in operation, and the estimation unit estimates the power consumption amount based on the voltage, the frequency, and a timing result of the timing unit.

In the disclosure, the timing unit times the operation time during which the electric device is in operation.

The estimation unit estimates the power consumption amount of the electric device based on the voltage and frequency of alternating current received by the electric device and the timing result of the timing unit.

In estimating the power consumption amount of the electric device, the length of time during which the electric device is actually consuming electric power may be taken into consideration, so the estimation accuracy of the power consumption amount of the electric device is improved.

The machine tool according to the disclosure further includes a temperature detection unit that detects a temperature at a predetermined position, and the estimation unit estimates the power consumption amount based on the voltage, the frequency, and a temperature detection result of the temperature detection unit.

In the disclosure, the temperature detection unit detects the temperature at the predetermined position.

The estimation unit estimates the power consumption amount of the electric device based on the voltage and frequency of alternating current received by the electric device and the temperature detection result of the temperature detection unit.

The temperature of the surrounding environment of the electric device may affect the power consumption amount of the electric device. Therefore, by taking into consideration the temperature detection result of the temperature detection unit in estimating the power consumption amount of the electric device, the estimation accuracy of the power consumption amount of the electric device is improved.

The machine tool according to the disclosure includes a plurality of the electric devices, and the estimation unit estimates the power consumption amount of each of the plurality of electric devices.

In the disclosure, the estimation unit estimates the power consumption amount of each of the plurality of electric devices. If the power consumption amount of each electric device is known, measures can be taken for each electric device to avoid consuming wasteful electric power.

A machine tool according to the disclosure includes: a plurality of electric devices that receive alternating current; a detection unit that collectively detects a voltage and a frequency of alternating current received by each electric device; and an estimation unit that estimates a power consumption amount of each electric device based on a detection result of the detection unit.

In the disclosure, the detection unit collectively detects the voltage and frequency of alternating current received by each electric device. Therefore, the machine tool may not include a detection unit for each electric device.

The estimation unit estimates the power consumption amount of each electric device based on the detection result of the detection unit. Therefore, it is possible to determine the power consumption amount of each electric device without using a watt-hour meter. If the power consumption amount of each electric device is known, measures can be taken for each electric device to avoid consuming wasteful electric power.

There is no need for the user or manufacturer to set the respective values of voltage and frequency used by the estimation unit for estimation in the machine tool according to the region where the machine tool is installed or the usage environment of the machine tool, which improves the convenience for the user and manufacturer. Further, estimation errors of the power consumption amount caused by forgetting to set or incorrectly setting the voltage and frequency may be prevented. Furthermore, even in the case of the voltage or frequency of alternating current fluctuating during use of the machine tool, the estimation accuracy of the power consumption amount of the electric device is improved.

A power consumption amount estimation method according to the disclosure is characterized by estimating, based on a voltage and a frequency of alternating current received by an electric device that is included in a machine tool and receives alternating current, a power consumption amount of the electric device.

In the disclosure, the machine tool includes the electric device. The computer estimates the power consumption amount of the electric device based on the voltage and frequency of alternating current received by the electric device. Therefore, it is possible to determine the power consumption amount of the electric device without using a watt-hour meter.

A computer program according to the disclosure is characterized by causing a computer to execute processing for estimating, based on a voltage and a frequency of alternating current received by an electric device that is included in a machine tool and receives alternating current, a power consumption amount of the electric device.

In the disclosure, the power consumption amount estimation method according to the disclosure may be realized by software using hardware elements of a computer.

### Effects of the Invention

According to the machine tool, the power consumption amount estimation method, and the computer program of the disclosure, it is possible to determine the power consumption amount of an electric device without using a watt-hour meter.

### BRIEF DESCRIPTION OF DRAWINGS

[FIG. 1] is a partial perspective view of the machine tool.
[FIG. 2] is a block diagram showing main units of the machine tool.
[FIG. 3] is a block diagram showing the configuration of the control apparatus.
[FIG. 4] is a flowchart showing the procedure of power consumption amount estimation processing executed in the machine tool.
[FIG. 5] is another block diagram showing main units of the machine tool.
[FIG. 6] is a block diagram showing the configuration of the control apparatus.
[FIG. 7] is a schematic diagram showing an example of the screen displayed on the display unit.

### DESCRIPTION

Embodiments of the disclosure will be described hereinafter. Up-down, front-rear, and left-right indicated by arrows in the drawings are used in the following description.

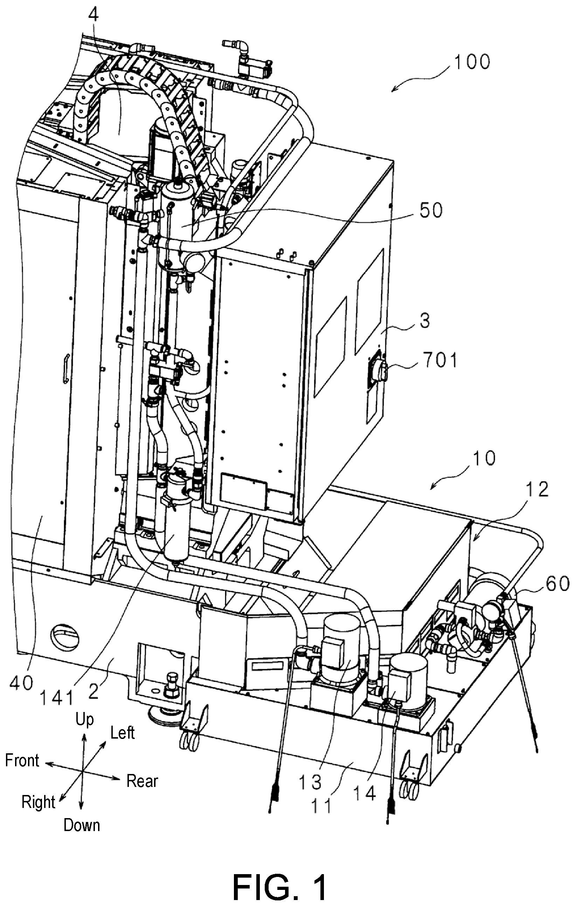

A machine tool 100 shown in FIG. 1 includes a control box 3 and a column 4 on a base 2 that is supported on a floor surface. A user operates the machine tool 100 from the front side (front). The column 4 is a support pillar that rises vertically at the center in the left-right direction of the rear part of the base 2. The machine tool 100 includes a machining chamber 40 on the front side of the column 4. The machining chamber 40 includes therein a machining table (not shown) that is movable in the front-rear and left-right directions. The machine tool 100 machines a workpiece (not shown) on the machining table.

The column 4 supports a spindle head (not shown) at the front part. The spindle head moves up and down along the column 4. The column 4 supports a tool changing device in front of the spindle head. The tool changing device includes a tool storage unit and a tool changing mechanism. The tool changing mechanism automatically exchanges any of multiple tools held by the tool storage unit with a tool mounted on a spindle.

The control box 3 is attached to the rear side of the column 4.

The machine tool 100 includes a cleaning liquid unit 10. The cleaning liquid unit 10 includes a tank 11, a recovery tank 12, a pump 13 (chip shower pump), a pump 14 (cyclone suction pump), and a pump 60 (CTS pump). The tank 11 is a box-shaped container and stores a cleaning liquid to be supplied into the machining chamber 40. The recovery tank 12, the pump 13, the pump 14, and the pump 60 are installed on the tank 11.

The cleaning liquid unit 10 is detachably attached to the rear side of the base 2. The recovery tank 12 recovers the used cleaning liquid. The recovery tank 12 includes a primary filter that performs primary filtration of the recovered cleaning liquid. The primary filter has a plate shape and has countless fine holes. The tank 11 includes a contamination tank and a pre-purification tank. The contamination tank is positioned below the primary filter. The contamination tank stores the cleaning liquid that has undergone the filtration processing of the primary filter. The contamination tank and the pre-purification tank are adjacent to each other. The cleaning liquid stored in the contamination tank flows into the pre-purification tank after undergoing the filtration processing of a pair of filters. The pair of filters has two filters facing each other with a predetermined interval, and each filter has a plate shape with countless holes that are smaller than the fine holes of the primary filter described above.

The pump 13, the pump 14, and the pump 60 suck up the cleaning liquid in the tank 11 and send the cleaning liquid to the machining chamber 40. The pump 13 is a pump for cleaning the machining chamber 40. The machining chamber 40 includes cleaning liquid nozzles (not shown) on the inner wall, and the discharge side of the pump 13 is connected to the cleaning liquid nozzles. The pump 13 sucks up the cleaning liquid in the tank 11 (pre-purification tank) and sends the cleaning liquid to the cleaning liquid nozzles, and the cleaning liquid nozzles spray the cleaning liquid into the machining chamber 40. The cleaning liquid washes away chips in the machining chamber 40 to the tank 11 (contamination tank).

The pump 14 is a pump for tool cleaning. The machining chamber 40 is provided with tool cleaning nozzles (not shown) on the inside, and the discharge side of the pump 14 is connected to the tool cleaning nozzles via piping. The pump 14 sucks up the cleaning liquid in the tank 11 (pre-purification tank) and sends the cleaning liquid to a cleaning filter 141 (cyclone filter) via piping. The cleaning filter 141 performs filtration processing on the cleaning liquid. The cleaning liquid that has undergone the filtration processing of the cleaning filter 141 is sent to a storage tank 50 via piping. During tool cleaning, the cleaning liquid in the storage tank 50 is sent to the tool cleaning nozzles in the machining chamber 40 via piping. The tool cleaning nozzles in the machining chamber 40 spray the cleaning liquid from the storage tank 50 onto the tool (not shown) during tool changing. The cleaning liquid washes away chips adhering to the tool before the tool is mounted on the spindle.

The pump 60 is a pump for both cooling and cleaning the tool and workpiece. The tool has a flow path inside that extends from the base end to the tip of the tool, and the tip of the tool is open. The discharge side of the pump 60 is connected to the base end of the tool via piping. The pump 60 sucks up the cleaning liquid in the tank 11 (pre-purification tank) and sends the cleaning liquid to the tool, and during machining, the tool sprays the cleaning liquid from the tip toward the machined surface of the workpiece. The cleaning liquid cools and cleans the tool and workpiece during machining.

The machine tool 100 may include a coolant pump. The coolant pump sucks up the cleaning liquid in the tank 11 (pre-purification tank) and sends the cleaning liquid via piping to nozzles provided around the tool and workpiece during machining, and the nozzles spray the cleaning liquid toward the tool and workpiece during machining.

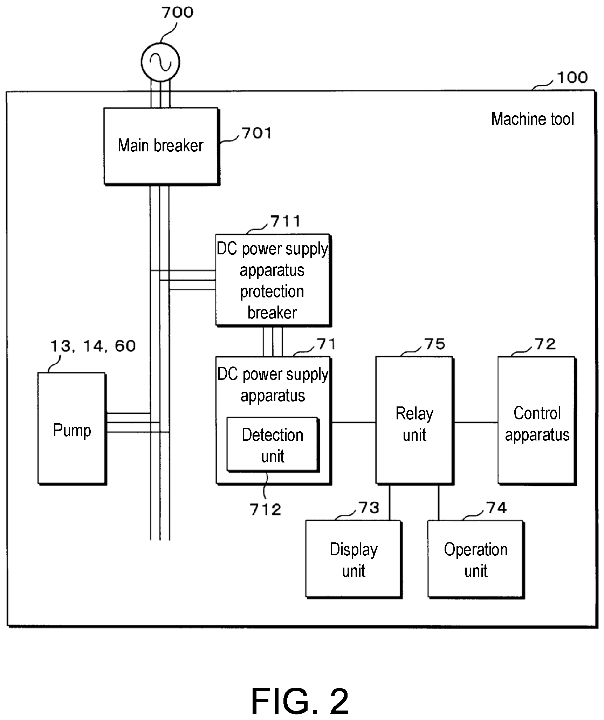

FIG. 2 is a block diagram showing main units of the machine tool 100. For simplification of the drawing, FIG. 2 collectively shows the pump 13, the pump 14, and the pump 60.

The pump 13 is an electric device including a pump motor that operates by receiving alternating current from an AC power supply 700. Similarly, the pump 14 and the pump 60 are also electric devices that operate by receiving alternating current. A main breaker 701 is interposed between the pumps 13, 14, and 60 and the AC power supply 700.

The machine tool 100 includes a DC power supply apparatus 71, a control apparatus 72, a display unit 73, an operation unit 74, and a relay unit 75.

The DC power supply apparatus 71 receives alternating current from the AC power supply 700 and converts alternating current into direct current. The control apparatus 72, the display unit 73, and the operation unit 74 receive direct current from the DC power supply apparatus 71 through the relay unit 75. A main breaker 701 and a DC power supply apparatus protection breaker 711 are interposed between the DC power supply apparatus 71 and the AC power supply 700.

The control box 3 shown in FIG. 1 houses, for example, the DC power supply apparatus 71, the control apparatus 72, and the relay unit 75.

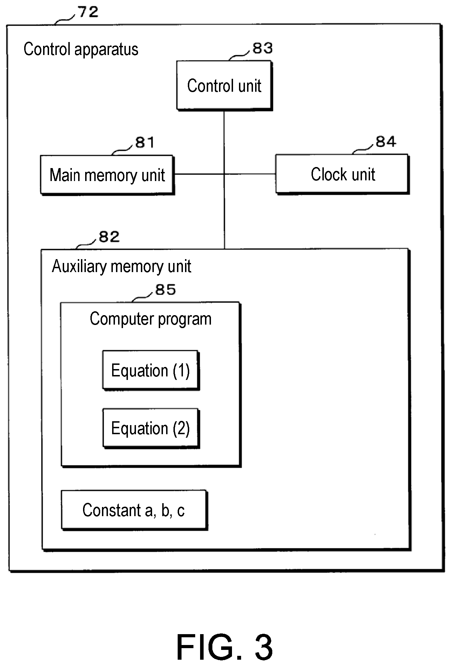

FIG. 3 is a block diagram showing the configuration of the control apparatus 72.

The control apparatus 72 includes a main memory unit 81, an auxiliary memory unit 82 (memory unit), a control unit 83, and a clock unit 84. The units of the control apparatus 72 are connected to each other via a bus.

The main memory unit 81 is volatile and is, for example, RAM (Random Access Memory).

The auxiliary memory unit 82 is non-volatile and includes ROM (Read Only Memory), flash memory, hard disk, SSD (Solid State Drive), etc.

The auxiliary memory unit 82 stores in advance a computer program for controlling the operation of the machine tool 100 and various data for executing the computer program.

The control unit 83 includes one or multiple processors such as CPU (Central Processing Unit), MPU (Micro-Processing Unit), or GPU (Graphics Processing Unit). The control unit 83 uses the main memory unit 81 as a working area and executes various arithmetic processing and control processing according to the computer program stored in the auxiliary memory unit 82. For example, the control unit 83 performs control processing for machining work, automatic tool changing, etc. in the machine tool 100. During control processing of machining work, the control unit 83 turns on/off each of the pumps 13, 14, and 60 at a predetermined timing according to the computer program for machining work. The control unit 83 may include a logic circuit (for example, FPGA).

The clock unit 84 measures the current time t.

The display unit 73 shown in FIG. 2 is, for example, a liquid crystal display. The operation unit 74 includes operation keys. The display unit 73 and the operation unit 74 constitute, for example, an operation panel located on the outer surface of the machining chamber 40. The display unit 73 and the operation unit 74 may be located in a terminal apparatus carried by the user of the machine tool 100.

The operation keys of the operation unit 74 may be hardware keys or software keys provided overlapping the display unit 73. In the case of the software keys, the display unit 73 is a touch panel. The operation keys include a power switch of the machine tool 100.

If the power consumption amount Wh of each of the pumps 13, 14, and 60 is known, measures can be taken for each of the pumps 13, 14, and 60 to avoid consuming wasteful electric power. However, providing a watt-hour meter for each of the pumps 13, 14, and 60 increases the cost of the machine tool 100.

Therefore, the control unit 83 estimates the power consumption amount Wh of each of the pumps 13, 14, and 60 and displays the estimation results on the display unit 73 in a distinguishable manner.

The auxiliary memory unit 82 stores in advance a computer program 85 for estimating the power consumption amount Wh and various data for executing the computer program 85.

The computer program 85 is capable of realizing the power consumption amount estimation method of the present embodiment in software using hardware elements of a computer, and includes the following equations (1) and (2). $W = aV + bf + c$ $Wh = W \times h$

Equation (1) is an equation for determining the power consumption W of each of the pumps 13, 14, and 60 based on a voltage V and a frequency f of alternating current received by each of the pumps 13, 14, and 60, and was experimentally obtained by the inventors. By approximating the power consumption W with a simple linear equation, calculation for estimating the power consumption amount Wh can be easily executed. The units of the voltage V, frequency f, and power consumption W are, for example, [V (volt)], [Hz (hertz)], and [W (watt)]. The ranges of the voltage V and frequency f to which equation (1) is applicable are, for example, 160 ≦V [V]≦280 and 49≦f [Hz] ≦61, and more preferably 180≦V [V]≦253 and 50≦f [Hz] ≦60. In experiments, the error between estimated values using equation (1) and actual measured values for each of the pumps 13, 14, and 60 was approximately 4.4%, which is sufficiently practical.

Equation (2) is an equation for determining the power consumption amount Wh of each of the pumps 13, 14, and 60 based on the power consumption W of each of the pumps 13, 14, and 60 and an operation time h during which each of the pumps 13, 14, and 60 was in operation. The units of the operation time h and power consumption amount Wh are, for example, [h (hour)] and [Wh (watt-hour)].

The auxiliary memory unit 82 stores constants a, b, and c in association with each of the pumps 13, 14, and 60. The constants a, b, and c may be experimentally determined for each of the pumps 13, 14, and 60, for example, and are provided to the machine tool 100 by the manufacturer during manufacturing of the machine tool 100.

It is noted that the constants a, b, and c may be provided to the machine tool 100 by the manufacturer or user operating the operation unit 74 after the machine tool 100 is shipped from the factory. Equation (1) or the constants a, b, and c may be downloaded by the control unit 83 from an external source (for example, a server).

As shown in FIG. 2, the DC power supply apparatus 71 includes a detection unit 712. The detection unit 712 detects the voltage and frequency of alternating current received from the AC power supply 700. The value of the voltage is, for example, an effective value. The detection unit 712 is not a watt-hour meter for directly determining the power consumption amount of each of the pumps 13, 14, and 60 from current and voltage.

The voltage and frequency detected by the detection unit 712 are equal to the voltage V and frequency f of alternating current that each of the pumps 13, 14, and 60 receives. That is, the detection unit 712 collectively detects the voltage V and frequency f related to each of the pumps 13, 14, and 60.

Generally, electric power is determined from current and voltage. Even if the voltages applied to the pumps 13, 14, and 60 are the same, the current flowing through each of the pumps 13, 14, and 60 differs depending on conditions such as the capacity of each of the pumps 13, 14, and 60 and usage environment. The usage environment includes the concentration of the cleaning liquid, the temperature in the room where the machine tool is used, the thickness of the piping, etc. Therefore, in the case of determining the power consumption amount of each of the pumps 13, 14, and 60 based on current and voltage, three watt-hour meters are used for the three pumps 13, 14, and 60, or one voltmeter and three ammeters are used.

On the other hand, the voltage V and frequency f related to each of the pumps 13, 14, and 60 are equal. Therefore, it is sufficient to provide one detection unit 712 that collectively detects the voltage V and frequency f of alternating current received by each of the pumps 13, 14, and 60. It is noted that the detection unit 712 may be one voltmeter and one frequency meter each.

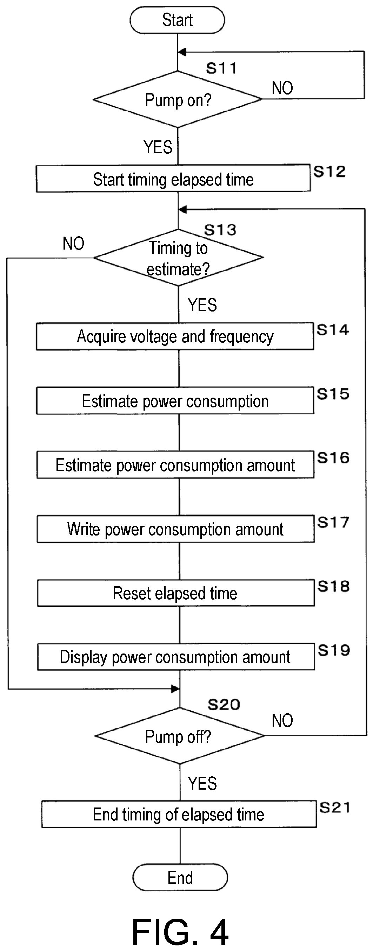

FIG. 4 is a flowchart showing the procedure of power consumption amount estimation processing executed in the machine tool 100. The control unit 83 executes the power consumption amount estimation processing according to the computer program 85. The following exemplifies processing for estimating the power consumption amount Wh of the pump 13.

The control unit 83 determines whether the pump 13 has been turned from off to on (S11), and in the case of the pump 13 remaining off (NO in S11), returns the processing to S11.

In the case of the pump 13 being turned on (YES in S11), the control unit 83 starts timing an elapsed time hb (S12). The control unit 83 in S12 performs timing of the elapsed time hb, for example, by counting up the number of clocks received by the control unit 83, or by turning on a timer included in the control apparatus 72.

The control unit 83 determines whether now is the timing to estimate the power consumption amount Wh of the pump 13 (S13). The timing to estimate the power consumption amount Wh is, for example, the time point at which the elapsed time hb reaches a predetermined time hc (for example, 0.1 [msec]) or more.

In the case of the timing to estimate the power consumption amount Wh of the pump 13 (YES in S13), the control unit 83 acquires the detection result of the detection unit 712 (that is, the voltage V and frequency f of alternating current received by the pump 13) (S14).

After processing of S14 is completed, the control unit 83 estimates the power consumption W of the pump 13 (S15). The control unit 83 in S15 determines the power consumption W by substituting the constants a, b, and c stored in the auxiliary memory unit 82 and the voltage V and frequency f of alternating current acquired in S14 into equation (1) stored in the auxiliary memory unit 82.

After processing of S15 is completed, the control unit 83 estimates the power consumption amount Wh of the pump 13 (S16). The control unit 83 in S16 determines the power consumption amount Wh by substituting the operation time h and the power consumption W determined in S15 into equation (2) stored in the auxiliary memory unit 82. Here, the operation time h to be substituted into equation (2) is the elapsed time hb converted into the unit [h] (in the case of the elapsed time hb being 0.1 [msec], the operation time h is approximately 2.8×10-8 [h]).

The control unit 83 writes information related to the power consumption amount Wh determined in S16 to the auxiliary memory unit 82 (S17). The information that the control unit 83 writes to the auxiliary memory unit 82 in S17 is, for example, the power consumption amount Wh, a cumulative operation time ha (ha=ha+hb), and a cumulative power consumption amount Wha (Wha=Wha+Whb). Here, Whb is the power consumption amount Wh for the elapsed time hb estimated in S16. The control unit 83 writes the power consumption amount Wh, the cumulative operation time ha, and the cumulative power consumption amount Wha to the auxiliary memory unit 82 in association with, for example, information identifying the pump 13 and a time t measured by the clock unit 84. The control unit 83 may also write the power consumption W and the operation time h to the auxiliary memory unit 82.

The control unit 83 resets the timing result of the elapsed time hb (S18) and continues timing the elapsed time hb.

The control unit 83 displays information related to the power consumption amount Wh determined in S16 on the display unit 73 (S19). The control unit 83 in S19 displays the power consumption amount Wh on the display unit 73 as, for example, a bar graph or line graph with time t as the horizontal axis and power consumption amount Wh as the vertical axis.

After processing of S 19 is completed, or in the case of it not being the timing to estimate the power consumption amount Wh of the pump 13 (NO in S13), the control unit 83 determines whether the pump 13 has been turned from on to off (S20).

In the case of the pump 13 remaining on (NO in S20), the control unit 83 returns the processing to S13.

In the case of the pump 13 being turned off (YES in S20), the control unit 83 ends the timing of the elapsed time hb (S21) and ends the power consumption amount estimation processing.

While the machine tool 100 is operating, the control unit 83 repeatedly executes the power consumption amount estimation processing.

Displaying the power consumption amount Wh of the pump 13 in a graph enables the user who visually recognizes the display unit 73 to intuitively grasp the state of the power consumption amount Wh. Further, using time t as the horizontal axis enables the user to intuitively grasp the temporal transition of the power consumption amount Wh.

It is noted that the control unit 83 is not limited to a configuration that displays the power consumption amount Wh in a graph, and may display the power consumption amount Wh in numbers, for example. Additionally, the control unit 83 may obtain an integrated value of the power consumption amount Wh per predetermined time period (for example, every hour from start of work to end of work) and display the integrated value on the display unit 73. The control unit 83 may obtain an integrated value of the power consumption amount Wh from a predetermined time point to the current time point and display the integrated value on the display unit 73.

The control unit 83 is not limited to a configuration that displays the power consumption amount Wh each time the power consumption amount Wh is estimated, and may be configured to display the power consumption amount Wh in the case of the user performing a predetermined operation on the operation unit 74, for example.

The control unit 83 executes power consumption amount estimation processing similar to the power consumption amount estimation processing shown in FIG. 4 for each of the pumps 14 and 60. Regarding the power consumption amount Wh of each of the pumps 13, 14, and 60, the control unit 83 displays on the display unit 73, for example, a stacked bar graph or grouped bar graph with time t as the horizontal axis and power consumption amount Wh as the vertical axis.

It is noted that the control unit 83 may display a total value of the power consumption amounts Wh of the pumps 13, 14, and 60 on the display unit 73. The power consumption amounts Wh of the pumps 13, 14, and 60 are not necessarily displayed in a distinguishable manner, and for example, a total value of two power consumption amounts Wh of the pumps 13, 14, and 60 and another power consumption amount Wh may be displayed to be distinguishable from each other. The graph is not limited to a bar graph or line graph, and may be a pie chart showing a ratio of the power consumption amounts Wh of the pumps 13, 14, and 60 to the power consumption amount of the entire machine tool 100, for example.

According to the machine tool 100 as described above, it is possible to determine the power consumption amount Wh of each of the pumps 13, 14, and 60 without using a watt-hour meter.

The control unit 83 in S15 and S16 of the power consumption amount estimation processing functions as an estimation unit in the embodiment. The control unit 83 functions as a timing unit in the embodiment from the start of timing of the operation time h in S12 to the end of timing of the operation time h in S21.

The electric devices for which Wh should be estimated are not limited to the pumps 13, 14, and 60, and may be a spindle motor, lighting fixtures, and the like. Furthermore, pumps other than the pumps 13, 14, and 60 may be used.

The constants a, b, and c may be common to the multiple pumps 13, 14, and 60.

The machine tool 100 may include multiple detection units instead of the detection unit 712. For example, three detection units detect the voltages V and frequencies f related to the three pumps 13, 14, and 60 in one-to-one correspondence. However, the configuration of the machine tool 100 is simpler in the case of the detection unit 712 detecting the voltage V and frequency f related to the pumps 13, 14, and 60 collectively.

The voltage V and frequency f of alternating current received by each of the pumps 13, 14, and 60 may be set in the machine tool 100 by the manufacturer or user. The voltage V and frequency f set by the manufacturer or user are stored in the auxiliary memory unit 82, for example. In this case, the detection unit 712 may be omitted. However, with the detection unit 712, there is no need for the user or manufacturer to set the respective values of voltage V and frequency f in the machine tool 100 according to the region where the machine tool 100 is installed, the usage environment of the machine tool 100, etc., which improves the convenience for the user and manufacturer. Further, estimation errors of the power consumption amount Wh caused by forgetting to set or incorrectly setting the voltage V or frequency f may be prevented. Furthermore, even in the case of the voltage V or frequency f fluctuating during use of the machine tool 100, the estimation accuracy of the power consumption amount Wh is improved.

The control unit 83 executes multiple types of processing such as estimation processing for estimating the power consumption amount Wh and display processing for displaying the estimation result. The multiple types of processing may be executed by one processor included in the control unit 83, or may be executed in a distributed manner by multiple processors included in the control unit 83. The processor that executes estimation processing and the processor that executes display processing may exist separately.

The control unit 83 may substitute a constant operation time h into equation (2) without timing the operation time h. However, using the timed operation time h makes it possible to take into consideration the length of time that each of the pumps 13, 14, and 60 actually consumed electric power, so the estimation accuracy of the power consumption amount Wh of each of the pumps 13, 14, and 60 is improved.

The equations for estimating the power consumption amount Wh are not limited to equations (1) and (2).

The power consumption amount estimation method of the present embodiment is not limited to a configuration realized by a computer (control apparatus 72) included in the machine tool 100. A computer external to the machine tool 100 (for example, a server having the computer program 85 and constants a, b, and c) may receive the voltage V, frequency f, and operation time h provided from the machine tool 100 and estimate the power consumption amount Wh.

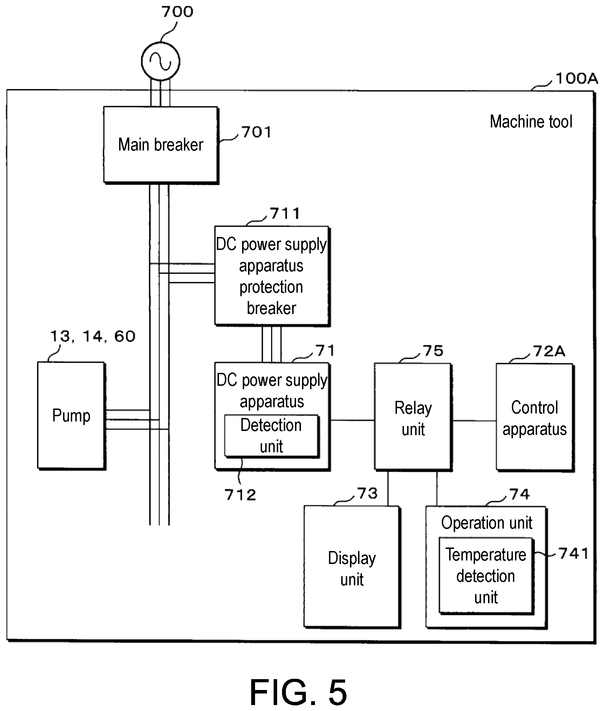

FIG. 5 is a block diagram showing main units of a machine tool 100A of Embodiment 2.

The machine tool 100A is substantially the same as the machine tool 100 of Embodiment 1, except that the machine tool 100A includes a control apparatus 72A instead of the control apparatus 72. The following will describe the differences from Embodiment 1, and other components that are the same as those in Embodiment 1 are denoted by the same reference numerals and the descriptions thereof are omitted.

The control apparatus 72A is substantially the same as the control apparatus 72 of Embodiment 1, except that the control apparatus 72A includes a temperature detection unit 741. The temperature detection unit 741 detects temperature at a predetermined position. It is desirable that the temperature detection result of the temperature detection unit 741 may replace the temperature of the surrounding environment of the pumps 13, 14, and 60. The temperature detection unit 741 of the present embodiment is mounted on a printed circuit board included in the operation unit 74 and detects temperature in the vicinity of the operation unit 74.

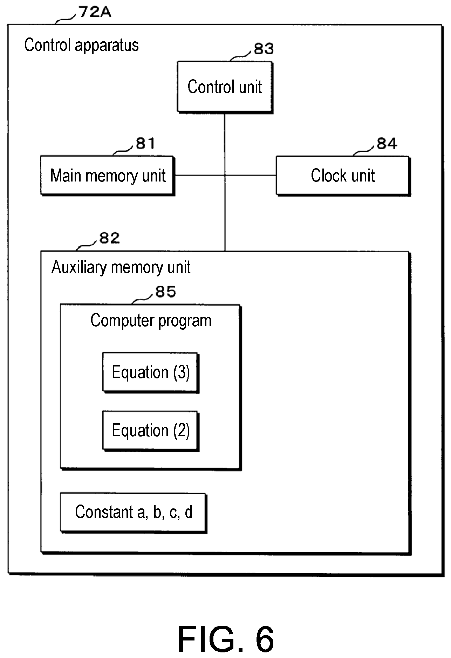

FIG. 6 is a block diagram showing the configuration of the control apparatus 72A.

The computer program 85 includes the following equation (3) instead of equation (1) of Embodiment 1. $W = aV + bf + c + dT$

Equation (3) was experimentally obtained by the inventors, and is equal to equation (1) with the fourth term "dT" added. The fourth term "dT" is a temperature T at a predetermined position multiplied by constant d.

The auxiliary memory unit 82 stores the constant d together with constants a, b, and c in association with each of the pumps 13, 14, and 60. The constant d may be experimentally obtained in the same manner as constants a, b, and c, and is given to the machine tool 100A by the manufacturer during manufacturing of the machine tool 100A.

The control unit 83 of the present embodiment also executes the power consumption amount estimation processing shown in FIG. 4. However, the control unit 83 in S14 acquires the detection result of the detection unit 712 (that is, the voltage V and frequency f of alternating current received by each of the pumps 13, 14, and 60) and also acquires the temperature detection result of the temperature detection unit 741 (that is, the temperature T at the predetermined position).

The control unit 83 in S15 determines the power consumption W by substituting the constants a, b, c, and d stored in the auxiliary memory unit 82, the voltage V and frequency f of alternating current acquired in S14, and the temperature T into equation (3) stored in the auxiliary memory unit 82.

The temperature of the surrounding environment of the pumps 13, 14, and 60 may affect the power consumption amount Wh of each of the pumps 13, 14, and 60. Therefore, by taking into consideration the temperature detection result of the temperature detection unit 741 in estimating the power consumption amount Wh, the estimation accuracy of the power consumption amount Wh of each of the pumps 13, 14, and 60 is improved.

It is noted that the machine tool 100A may include multiple temperature detection units instead of the temperature detection unit 741. For example, three temperature detection units detect the temperature of the surrounding environment in the vicinity of the three pumps 13, 14, and 60 in one-to-one correspondence. However, the configuration of the machine tool 100A is simpler in the case of the temperature detection unit 741 detecting the temperature T at the predetermined position.

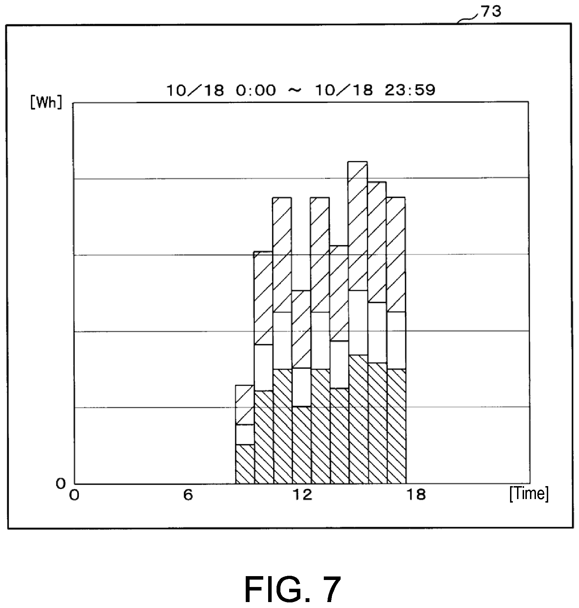

FIG. 7 is a schematic diagram showing an example of a screen displayed on the display unit 73.

The control unit 83 displays a stacked bar graph on the display unit 73. The horizontal axis represents hourly time periods from 0:00 to 23:59 of the current day. The vertical axis represents the integrated value of the estimated power consumption amount Wh of each of the pumps 13, 14, and 60 in each time period. The bar graph with downward-sloping hatching represents pump 13, the white bar graph represents pump 14, and the bar graph with upward-sloping hatching represents pump 60.

In the case of estimating the power consumption amounts Wh of a spindle motor, lighting fixtures, and the like together with the power consumption amounts Wh of the pumps 13, 14, and 60, the control unit 83 may display bar graphs representing the spindle motor, lighting fixtures, and the like on the display unit 73 by adding such bar graphs to the stacked bar graph shown in FIG. 7.

The embodiments disclosed herein should be considered illustrative in all respects and not restrictive. The scope of the present invention is intended to include not only the above-described meanings but also meanings equivalent to the claims and all modifications within the scope of the claims.

The constituent elements (technical features) disclosed in each embodiment may be combined with each other, and new technical features can be formed by the combinations. Moreover, the independent claims and dependent claims described in the claims may be mutually combined in all possible combinations regardless of the citation format. Furthermore, although the claims use a format that describes claims citing two or more other claims (multi-claim format), the present invention is not limited thereto. A format that describes multi-claims citing at least one multi-claim (multi-multi claims) may be used.

### Description of Reference Numerals

100, 100A machine tool
13, 14, 60 pump (electric device)
712 detection unit
741 temperature detection unit
82 auxiliary memory unit (memory unit)
83 control unit (estimation unit, timing unit)
85 computer program

## Claims

1. A machine tool, **characterized by** comprising:
an electric device that receives alternating current; and
an estimation unit that estimates a power consumption amount of the electric device based on a voltage and a frequency of the alternating current received by the electric device.

2. The machine tool as claimed in claim 1, further comprising a detection unit that detects the voltage and the frequency,
wherein the estimation unit estimates the power consumption amount based on a detection result of the detection unit.

3. The machine tool as claimed in claim 1 or 2, further comprising a memory unit that stores the following equation (1) and constants a, b, and c for determining power consumption W based on the voltage V and the frequency f,
wherein the estimation unit estimates the power consumption amount based on the following equation (1) and the constants stored in the memory unit, $W = aV + bf + c$

4. The machine tool as claimed in claim 1 or 2, further comprising a timing unit that times an operation time during which the electric device is in operation,
wherein the estimation unit estimates the power consumption amount based on the voltage, the frequency, and a timing result of the timing unit.

5. The machine tool as claimed in claim 1 or 2, further comprising a temperature detection unit that detects a temperature at a predetermined position,
wherein the estimation unit estimates the power consumption amount based on the voltage, the frequency, and a temperature detection result of the temperature detection unit.

6. The machine tool as claimed in claim 1 or 2, comprising a plurality of the electric devices,
wherein the estimation unit estimates the power consumption amount of each of the plurality of electric devices.

7. A machine tool, **characterized by** comprising:
a plurality of electric devices that receive alternating current;
a detection unit that collectively detects a voltage and a frequency of alternating current received by each electric device; and
an estimation unit that estimates a power consumption amount of each electric device based on a detection result of the detection unit.

8. A power consumption amount estimation method, **characterized by** estimating, based on a voltage and a frequency of alternating current received by an electric device that is included in a machine tool and receives alternating current, a power consumption amount of the electric device.

9. A computer program, **characterized by** causing a computer to execute processing for estimating, based on a voltage and a frequency of alternating current received by an electric device that is included in a machine tool and receives alternating current, a power consumption amount of the electric device.
